# FASCICULE DE BREVET EUROPEEN

(11) **EP 2 069 813 B1**
(45) Date de publication et mention de la délivrance du brevet: **03.04.2013**
(21) Numéro de dépôt: 07823484.6
(22) Date de dépôt: 07.09.2007
(51) Int. Cl.: G01R 31/308, G01R 1/07

(54) **PROCÉDÉ ET DISPOSITIF POUR CARACTÉRISER UN SIGNAL ÉLECTRIQUE SE PROPAGEANT DANS UN ÉCHANTILLON**
VERFAHREN UND EINRICHTUNG ZUR CHARAKTERISIERUNG EINES SICH DURCH EINE PROBE AUSBREITENDEN ELEKTRISCHEN SIGNALS
METHOD AND DEVICE FOR CHARACTERISING AN ELECTRIC SIGNAL PROPAGATING THROUGH A SAMPLE

(30) Priorité: 20.09.2006 FR 0608214
(43) Date de publication de la demande: 17.06.2009
(73) Titulaire: Université Paris Sud, 91400 Orsay (FR); Centre National de la Recherche Scientifique, 75794 Paris Cedex 16 (FR)
(72) Inventeur: MANGENEY, Juliette, F-94230 Cachan (FR); CROZAT, Paul, F-91940 Les Ulis (FR); MEIGNIEN, Loïc, F-91940 Gometz le Chatel (FR); LOURTIOZ, Jean-Michel, F-91400 Orsay (FR)
(74) Mandataire: Pontet, Bernard
(86) Numéro de dépôt international: PCT/FR2007/001446
(87) Numéro de publication internationale: WO 2008/034962

(56) Documents cités:
- EP-A- 0 921 404
- WO-A-97/45747
- SHAH S A ET AL: "Separating temporally-overlapped waveforms with electrooptic sampling" OPTICAL AND QUANTUM ELECTRONICS CHAPMAN & HALL UK, vol. 28, no. 7, juillet 1996 (1996-07), pages 953-960, XP008078778 ISSN: 0306-8919
- KEIL U D ET AL: "Ultrafast Pulse Generation in Photoconductive Switches" IEEE JOURNAL OF QUANTUM ELECTRONICS, IEEE SERVICE CENTER, PISCATAWAY, NJ, US, vol. 32, no. 9, septembre 1996 (1996-09), XP011051465 ISSN: 0018-9197
- "Electro-optic detection of THz radiation in LiTaO3, LiNbO3 and ZnTe" APPLIED PHYSICS LETTERS, AIP, AMERICAN INSTITUTE OF PHYSICS, MELVILLE, NY, US, vol. 70, no. 23, 9 juin 1997 (1997-06-09), pages 3069-3071, XP012017995 ISSN: 0003-6951

## Description

### Domaine technique

La présente invention concerne un procédé et un dispositif d'échantillonnage électro-optique pour caractériser un signal électrique, et notamment pour déterminer la direction de propagation du signal électrique.

Le domaine d'application de l'invention est l'échantillonnage électro-optique, la mesure et la caractérisation de signaux électriques, notamment d'impulsions électriques ultracourtes se propageant dans des structures guidées.

### Etat de la technique antérieure

Des domaines tels que les communications optiques et la microélectronique nécessitent des composants de plus en plus rapides. Les moyens actuels dans le domaine de la communication sont de 10 gigabits par seconde en mono canal sur les lignes posées. Des débits de 40 gigabits par seconde sont déjà validés en recherche et commencent à être installés, et les perspectives portent sur des débits de 80 gigabits par seconde.

L'utilisation d'outils de mesure conventionnels pour mesurer des signaux électriques sur des composants électroniques et optoélectroniques est limitée à des fréquences inférieures à 210 gigahertz avec des analyseurs de réseaux et à des fréquences inférieures à 110 gigahertz avec des oscilloscopes, ce qui correspond à une résolution temporelle de quelques picosecondes.

Pour des fréquences plus élevées, on peut utiliser des outils de mesures basés sur de l'échantillonnage électro-optique. Le principe de la technique d'échantillonnage électro-optique est largement décrit dans la littérature, notamment dans les documents [1] à [4] référencés en dernière page. Il est basé sur l'effet Pockels, c'est-à-dire sur un changement de propriétés optiques d'un cristal électro-optique sous l'effet d'un champ électrique. Un cristal électro-optique est placé par exemple à proximité d'un échantillon sur lequel se propage un signal électrique. Les indices de réfraction du cristal changent en présence du champ électrique . Un faisceau lumineux de mesure passant dans le cristal voit sa polarisation changer du fait de la variation d'indice du cristal induite par le champ électrique. Une mesure de cette variation de polarisation permet de déduire la valeur du champ électrique appliqué. Dans un dispositif tel que celui présenté dans le document [2], le faisceau lumineux de mesure se propage dans le cristal perpendiculairement à la direction de propagation du signal électrique.

Les documents WO 97/45 747 A et S.A. Shah et al.: «Separating temporally-over lapped waveforms with electrooptic sampling», Optical and Quantum Electronics, vol. 28, no. 7 juillet 1996, pages 953 à 960, présentent des procédés et dispositifs électro-optiques pour caractériser des signeaux électriques.

-Cependant, les dispositifs d'échantillonnage électro-optiques actuels ne permettent pas de déterminer la direction de propagation d'un signal électrique. De tels dispositifs ont donc le désavantage de ne pas pouvoir faire la distinction entre deux signaux se propageant dans des directions opposées. Ils ne permettent donc pas de faire la distinction entre d'une part un signal électrique d'origine se propageant dans un circuit et d'autre part des signaux échos ou des rebonds parasites du signal d'origine. Ces échos ou rebonds sont généralement émis suite à un phénomène de désadaptation d'impédance dans le circuit et se propagent généralement dans la direction opposée au signal d'origine. Or, la caractérisation de ces effets parasites est importante, car ces effets perturbent le signal d'origine.

De plus, les dispositifs d'échantillonnage électro-optiques fibrés actuels sont limités en fréquence.

Le but de l'invention est de proposer un procédé et un dispositif pour caractériser un signal électrique, permettant de déterminer la direction de propagation d'un signal électrique, et pouvant présenter en outre au moins un des avantages suivants :
- la possibilité de déterminer la présence d'échos parasites et de caractériser ces échos, et
- une résolution temporelle améliorée par rapport à l'état de l'art des systèmes électro-optiques fibrés.

### Exposé de l'invention

Cet objectif est atteint avec un procédé pour caractériser un signal électrique, comprenant :
- une propagation d'un premier faisceau lumineux à travers un milieu électro-optique selon une première direction de propagation, au moins une propriété optique du milieu variant lorsqu'il est soumis à un champ électrique,
- une propagation d'un deuxième faisceau lumineux à travers le milieu électro-optique selon une deuxième direction de propagation différente de la première direction,
- pour chacun des faisceaux lumineux, une mesure d'une variation d'une propriété optique du faisceau lumineux due à la propagation du faisceau dans le milieu électro-optique, et
- une détermination, à partir des mesures, d'une direction de propagation d'un signal électrique soumettant le milieu électro-optique à un champ électrique.

Dans un mode de réalisation, les propagations des deux faisceaux lumineux à travers le milieu électro-optique sont sensiblement simultanées, de sorte que le signal électrique modifie au moins une propriété optique du milieu électro-optique lors des propagations des faisceaux lumineux à travers le milieu électro-optique.

On peut aussi imaginer un autre mode de réalisation pour lequel les propagations des deux faisceaux lumineux à travers le milieu électro-optique sont espacées temporellement. Dans ce cas, le même signal électrique, dont on cherche à déterminer la direction de propagations, se propage deux fois de suite à proximité du milieu électro-optique, de manière à modifier au moins une propriété optique du milieu électro-optique lors de chacune des propagations des faisceaux lumineux à travers le milieu électro-optique.

La détermination de la direction de propagation du signal électrique utilise le fait que la variation d'une propriété optique pour chaque faisceau lumineux dépend de la direction de propagation du faisceau à travers le milieu par rapport à la direction de propagation du signal électrique.

De manière préférentielle, la direction de propagation d'un des faisceaux lumineux est sensiblement colinéaire à la direction de propagation du signal électrique. De cette façon, la direction de propagation d'un des faisceaux lumineux est parallèle à la direction de propagation du signal électrique. La géométrie du problème et la détermination de la direction de propagation du signal électrique est alors simplifiée.

De la même manière, les première et deuxième directions de propagation sont préférentiellement sensiblement opposées. Ainsi, les directions de propagation des faisceaux lumineux sont parallèles. La géométrie du problème et la détermination de la direction de propagation du signal électrique est alors simplifiée. Dans cette variante, les deux faisceaux peuvent se propager dans le milieu selon des trajectoires sensiblement confondues.

Au moins un des faisceaux lumineux peut consister en une impulsion optique. Le procédé selon l'invention peut comprendre en outre une génération des deux faisceaux lumineux par une même impulsion optique. Plus l'impulsion est courte, et plus la résolution temporelle d'une mesure sera faible, c'est à dire bonne (pouvoir de résolution temporelle élevé).

L'une des propriétés du milieu variant lorsqu'il est soumis à un champ électrique peut être par exemple un indice de réfraction du milieu. Les propriétés du milieu variant lorsqu'il est soumis à un champ électrique peuvent par exemple dans le cas d'un cristal biréfringent comprendre plusieurs indices de réfaction. De manière générale, un champ électrique modifie le tenseur de permittivité d'un milieu électro-optique, ce qui peut influer sur un indice de réfraction du milieu mais également sur d'autres propriétés.

Pour au moins un des faisceaux lumineux, la mesure peut comprendre une mesure d'une variation de la polarisation du faisceau lumineux ou directement une mesure d'une variation d'intensité du faisceau (une variation d'indice pouvant modifier en effet la transmittance du milieu electro-optique ce qui conduit à une variation d'intensité du faisceau transmis). Le procédé selon l'invention peut comprendre en outre une transcription de la variation de polarisation du faisceau lumineux en une variation d'intensité du faisceau lumineux, par exemple au moyen d'un polariseur.

. Le procédé selon l'invention peut comprendre en outre une génération du signal électrique se propageant, permettant par exemple un déclenchement de la propagation du signal électrique dans un échantillon tel un circuit imprimé. La génération du signal électrique peut comprendre une transcription d'une impulsion optique de déclenchement en le signal électrique. Le procédé selon l'invention peut comprendre en outre une génération de l'impulsion optique de déclenchement et d'au moins un des faisceaux lumineux (de préférence les deux) par une même impulsion optique initiale. Le procédé selon l'invention peut aussi comprendre en outre une variation d'un retard entre la génération du signal électrique et les propagations des faisceaux lumineux à travers le milieu électro-optique.

Le signal électrique qui se propage se traduit par une propagation d'un champ électrique dans le milieu électro-optique. Le procédé selon l'invention peut en outre comprendre une détermination d'une valeur du signal électrique ou du champ électrique. Pendant sa propagation, le champ électrique fait varier au moins une propriété optique du milieu. Lorsque les faisceaux lumineux se propagent dans le milieu, la variation de la propriété optique du milieu peut faire varier une propriété optique du premier et du deuxième faisceau lumineux. Ainsi, le premier et deuxième faisceau lumineux interagissent avec le signal électrique par l'intermédiaire du milieu électro-optique. Le temps d'interaction d'un des faisceaux avec le champ ou le signal électrique dépend notamment de l'angle (ou de la différence) entre la direction de propagation dudit faisceau et la direction de propagation du signal électrique. La mesure de la variation de la propriété optique d'un des faisceaux (typiquement la polarisation) permet de déterminer la valeur du signal ou du champ au moment où le faisceau interagit avec le signal par l'intermédiaire du milieu. Le procédé selon l'invention peut comprendre en outre une détermination d'un profil temporel du signal ou du champ électrique. La détermination du profil temporel peut être réalisé par exemple par des propagations successives du premier ou deuxième faisceau à travers le milieu, sous la forme d'une pluralité d'impulsions optiques. Chaque impulsion optique interagit avec une partie différente du signal électrique, et permet ainsi de déterminer différentes valeurs du signal ou du champ électrique au cours du temps.

Le procédé selon l'invention peut comprendre en outre une caractérisation d'échos parasites et/ou de rebonds du signal électrique. La caractérisation d'un écho (ou d'un rebond) peut comprendre la détermination de la valeur du champ électrique de l'écho, la détermination d'un profil temporel de l'écho, la détermination du délai entre l'écho et le signal électrique à l'origine de l'écho, ou la détermination de la direction de propagation de l'écho.

Suivant encore un autre aspect de l'invention, il est proposé un dispositif pour caractériser un signal électrique, comprenant :
- des moyens pour qu'un premier faisceau lumineux se propage à travers un milieu électro-optique selon une première direction de propagation, au moins une propriété optique du milieu variant lorsqu'il est soumis à un champ électrique,
- des moyens pour qu'un deuxième faisceau lumineux se propage à travers le milieu électro-optique selon une deuxième direction de propagation différente de la première direction,
- pour chacun des faisceaux lumineux, des moyens pour mesurer une variation d'une propriété optique du faisceau lumineux due à la propagation du faisceau dans le milieu électro-optique, et
- des moyens pour déterminer, à partir des mesures de variation, une direction de propagation d'un signal électrique soumettant le milieu électro-optique à un champ électrique.

Le dispositif peut être agencé pour que les première et deuxième directions de propagation des faisceaux lumineux soient sensiblement opposées.

Le dispositif peut être agencé pour que les deux faisceaux lumineux aient des trajectoires de propagation dans le milieu sensiblement confondues.

Le dispositif peut être agencé pour que la direction de propagation d'un des faisceaux lumineux soit sensiblement colinéaire à la direction de propagation du signal électrique.

Le dispositif selon l'invention peut comprendre en outre des moyens pour générer le premier et le deuxième faisceau lumineux à partir d'une même impulsion optique. Ces moyens permettent de limiter un éventuel décalage temporel entre les deux faisceaux.

Pour au moins un des faisceaux lumineux, les moyens de mesure peuvent comprendre des moyens pour mesurer une variation de la polarisation du faisceau lumineux, ou des moyens pour mesurer une variation d'intensité du faisceau. Le dispositif selon l'invention peut comprendre en outre des moyens pour transcrire une variation de polarisation du faisceau lumineux en une variation d'intensité du faisceau lumineux.

Le dispositif selon l'invention peut comprendre en outre des moyens pour déterminer une valeur du signal ou du champ électrique, et/ou des moyens pour déterminer un profil temporel du signal électrique ou du champ électrique induit.

Le dispositif selon l'invention peut comprendre en outre des moyens pour caractériser des échos parasites et/ou des rebonds du signal électrique.

Le milieu électro-optique peut comprendre un cristal électro-optique, de préférence un cristal de Tantalate de Lithium (LiTaO₃), de Telluride de Zinc (ZnTe) ou de (diéthylamino)sulfur trifluoride (DAST).

L'indice de réfraction du milieu électro-optique à une fréquence optique d'au moins un des faisceaux lumineux peut être sensiblement égale à l'indice de réfraction du milieu électro-optique à une fréquence du signal électrique.

Le dispositif selon l'invention peut comprendre en outre des moyens pour générer le signal électrique se propageant, par exemple afin d'exciter un échantillon tel un circuit imprimé. Les moyens de génération du signal électrique peuvent comprendre des moyens pour transcrire une impulsion optique de déclenchement en le signal électrique. Le dispositif selon l'invention peut comprendre en outre des moyens pour générer l'impulsion optique de déclenchement et au moins un des faisceaux lumineux à partir d'une même impulsion optique initiale. Le dispositif selon l'invention peut comprendre en outre des moyens pour varier un retard entre la génération du signal électrique se propageant et les propagations des faisceaux lumineux à travers le milieu.

Le signal électrique peut se propager dans un échantillon à caractériser tel un circuit imprimé.

Enfin, le milieu électro-optique peut faire partie d'une sonde électro-optique prévue pour être placée à proximité d'un échantillon devant être caractérisé et dans lequel se propage le signal électrique. La sonde électro-optique mise en oeuvre dans le dispositif comprend :
- un milieu électro-optique dont au moins une propriété optique varie lorsqu'il est soumis à un champ électrique,
- des moyens pour collecter un premier et un deuxième faisceau lumineux ayant sensiblement une même direction de propagation vers la sonde électro-optique, et
- des moyens pour que le premier faisceau lumineux et le deuxième faisceau lumineux se propagent à travers le milieu électro-optique selon des directions de propagation différentes.

La sonde électro-optique peut être agencée pour que les directions de propagation des faisceaux lumineux à travers le milieu soient sensiblement opposées.

La sonde électro-optique peut être agencée pour que les deux faisceaux aient des trajectoires de propagation à travers le milieu sensiblement confondues.

La sonde électro-optique peut comprendre deux prismes situés respectivement le long d'une première et deuxième face latérale du milieu électro-optique, les prismes étant disposés sensiblement symétriquement par rapport à un plan passant à travers le milieu.

Le milieu électro-optique peut avoir sensiblement la forme d'un parallélépipède rectangle, comprendre deux faces dites supérieure et inférieure opposées et sensiblement perpendiculaires aux faces latérales, la face inférieure étant prévue pour être placée à proximité d'un échantillon dans lequel se propage un signal électrique, et chaque prisme peut comprendre :
- une première face le long d'une des faces latérales,
- une deuxième face prévue pour collecter le premier ou deuxième faisceau lumineux, et formant avec ladite une des faces latérales et du côté de la face supérieure un angle sensiblement droit,
- une troisième face formant avec ladite une des faces latérales et du côté de la face inférieure un angle aigu, la troisième face étant agencée pour réfléchir le premier ou le deuxième faisceau de la deuxième face vers le milieu électro-optique ou inversement. La sonde électro-optique peut être agencée pour que la direction de propagation d'un des faisceaux lumineux à travers le milieu soit sensiblement parallèle à la face inférieure du milieu.

### Description des figures et modes de réalisation

D'autres avantages et particularités de l'invention apparaîtront à la lecture de la description détaillée de mises en oeuvre et de modes de réalisation nullement limitatifs, et des dessins annexés suivants :
- la figure 1 illustre schématiquement un mode de réalisation préférentiel d'un dispositif selon l'invention,
- la figure 2 est une vue agrandie d'une sonde électro-optique du dispositif de la figure 1, et
- la figure 3 illustre deux signaux mesurés par un dispositif selon l'invention.

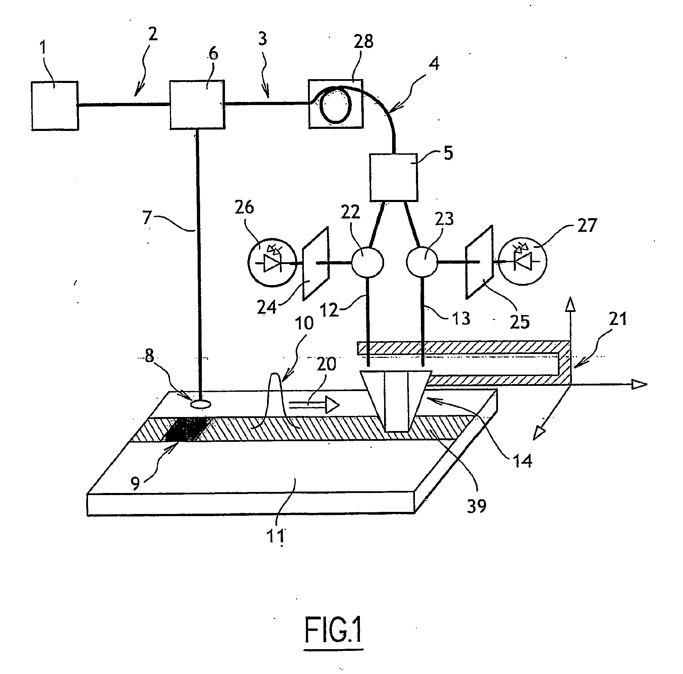

On va décrire, en référence aux figures 1 à 3, un mode de réalisation préférentiel du dispositif selon l'invention, mettant en oeuvre un procédé selon l'invention.

Le dispositif comprend des moyens 1, 5 pour émettre un premier et un deuxième faisceau lumineux 18, 19. Une sonde électro-optique 14 comprenant un cristal électro-optique 17 est agencée pour collecter les faisceaux émis et les faire se propager à travers le cristal 17 selon deux directions de propagation différentes. La sonde électro-optique est prévue pour être située à proximité d'un échantillon 11 tel un circuit intégré, dans lequel se propage un signal électrique 10. Des moyens 24-27 pour réaliser des mesures sur les faisceaux ayant traversés le cristal permettent de déterminer la direction de propagation 20 du signal électrique dans le circuit.

De manière générale, le signal électrique se propage le long d'une ligne 39 du circuit intégré 11 à caractériser. La détermination de la direction de propagation 20 du signal électrique consiste donc en une détermination du sens de propagation du signal électrique le long de la ligne 39.

Le principe général de l'invention est le suivant. Le signal électrique 10 qui se propage dans le circuit 11 induit une propagation d'un champ électrique dans le milieu électro-optique 17. Pendant sa propagation, le champ électrique fait varier au moins une propriété otique du milieu 17 telle que son indice de réfraction. Lorsque les faisceaux lumineux 18, 19 se propagent dans le milieu 17, la variation de la propriété optique du milieu fait varier une propriété optique du premier 18 et/ou du deuxième 19 faisceau lumineux, notamment leur polarisation. Le temps d'interaction d'un des faisceaux avec le champ électrique dépend notamment de l'angle entre la direction de propagation dudit faisceau et la direction de propagation du signal électrique. Les directions de propagation des faisceaux dans le milieu sont différentes, de sorte que les temps d'interaction de chaque faisceau avec le champ électrique sont différents. La variation de la propriété optique du premier faisceau au cours du temps est donc différente de celle du deuxième faisceau. La différence entre ces variations permet de déterminer la direction de propagation 20 du signal électrique 10.

Les moyens pour émettre les premiers et deuxième faisceaux lumineux comprennent une source laser 1, reliée via une fibre optique 2 à un premier coupleur optique 6. La dispersion introduite par les fibres optiques est gérée : on peut par exemple utiliser des fibres optiques pour lesquelles la dispersion est faible aux longueurs d'onde et aux puissances véhiculées, ou des moyens de compensation des phénomènes de dispersion (comme des fibres à dispersion négative). Le laser 1 délivre des impulsions optiques d'une durée de 200 femtosecondes, de longueur d'onde 15550 nanomètres et avec un taux de répétition de 14 mégahertz. Le coupleur 6 sépare chaque impulsion en une impulsion optique de déclenchement sur une première voie et une impulsion optique d'analyse sur une deuxième voie.

Dans la première voie, l'impulsion optique de déclenchement est transportée le long d'une fibre optique 7 dont l'extrémité orientée vers le circuit 11 est munie d'une lentille 8, puis est convertie par un convertisseur optique-électrique 9 en un signal électrique (typiquement une impulsion électrique gaussienne). L'impulsion optique focalisée par la lentille 8 sur le convertisseur 9 permet donc de déclencher une propagation du signal électrique 10 dans une partie 39 du circuit intégré 11. Les moyens pour réaliser cette conversion comprennent un photoconducteur rapide agencé pour que le signal électrique soit le plus court possible. Le photoconducteur a de manière préférentielle été irradié avec des ions de la couche semiconductrice active du circuit intégré, de sorte qu'il soit le plus rapide possible et que le signal électrique soit le plus court possible. En effet, plus le signal électrique 10 est court, et plus on peut caractériser la réponse du circuit 11 à une haute fréquence.

Dans la deuxième voie, l'impulsion optique d'analyse est dirigée via des fibres optiques 3, 4 jusqu'à un deuxième coupleur 5, puis est séparée par le coupleur 5 en une première et une deuxième impulsion optique correspondant respectivement au premier et deuxième faisceau lumineux. La première impulsion optique 18 est dirigée jusqu'au cristal 17 via un premier circulateur fibré 22 et une première fibre optique 12 flexible couplée optiquement à la sonde électro-optique 14. De même, la deuxième impulsion optique 19 est dirigée jusqu'au cristal 17 via un deuxième circulateur fibré 23 et une deuxième fibre optique 13 flexible couplée optiquement à la sonde électro-optique 14. Les impulsions optiques 18, 19 étant générées simultanément par une même impulsion laser, elles se propagent quasi simultanément à l'intérieur du cristal électro-optique de la sonde 14.

La sonde électro-optique 14 consiste en une tête prismatique comprenant le cristal électro-optique 17 placé entre un premier 15 et un deuxième 16 prisme. L'assemblage des prismes peut se faire par une méthode telle qu'un collage par adhésion moléculaire ou à l'aide d'une colle optique. Dans le cas de la colle optique, la colle utilisée a un indice sensiblement identique à celui du cristal électro-optique. Le cristal consiste de manière préférentielle en un cristal de ZnTe. Les prismes sont formés dans un matériau classiquement utilisé en optique, tel un verre de type BK7. Le cristal électro-optique a sensiblement la forme d'un parallélépipède rectangle. Les deux prismes sont situés respectivement contre une première 29 et une deuxième 30 face latérale du cristal. Ces deux faces latérales sont opposées, de sorte que la sonde possède un plan de symétrie passant dans le cristal et entre les deux prismes. Le cristal possède en outre une face dite supérieure 32 orientée vers les fibres flexibles 12, 13, et une face inférieure 31 prévue pour être placée à proximité d'une partie 39 du circuit intégré 11. Les faces inférieure 31 et supérieure 32 sont opposées et sensiblement perpendiculaires aux deux faces latérales 29, 30.

Chaque prisme possède en outre : .
- une première face le long d'une des faces latérales 29 ou 30,
- une deuxième face 33 ou 35 prévue pour collecter le premier 18 ou deuxième 19 faisceau lumineux, et formant avec ladite une des faces latérales 29 ou 30 et du côté de la face supérieure 32 un angle sensiblement droit,
- une troisième face 34 ou 36 formant avec ladite une des faces latérales 29 ou 30 et du côté de la face inférieure 31 un-angle-aigu A, ladite troisième face étant agencée pour réfléchir le premier 18 ou le deuxième 19 faisceau de la deuxième face 33 ou 35 vers le milieu électro-optique 17 ou inversement.

La deuxième face des deux prismes sont orientées vers les fibre 12, 13, et sont toutes deux sensiblement perpendiculaires aux directions de propagation des faisceaux 18, 19 vers la sonde électro-optique 14. Un traitement anti reflet a été déposé sur la deuxième face 33, 35 de chaque prisme.

En sortie des fibres 12, 13, les impulsions optiques 18, 19 se propagent toutes deux sensiblement perpendiculairement au plan des faces 32, 33, 35 du cristal et des prismes. La première impulsion optique 18 sort de la première fibre 12, est collectée par la deuxième face 33 du premier prisme 15, est réfléchie vers le cristal 17 par la troisième face oblique 34 du premier prisme 15, pénètre dans le cristal par la première face latérale 29 du cristal, traverse le cristal, ressort du cristal par la deuxième face latérale 30 du cristal, est réfléchie vers la deuxième face 35 du deuxième prisme 16 par la troisième face oblique 36 du deuxième prisme 16, et pénètre à l'intérieure de la deuxième fibre 13.

La deuxième impulsion optique 19 suit le parcours inverse. Elle sort donc de la deuxième fibre 13, traverse le cristal de la deuxième face latérale 30 à la première face latérale 29, et pénètre dans la première fibre 12.

Ainsi, les prismes redirigent les impulsions 18, 19 qui ont sensiblement une même direction de propagation avant de pénétrer dans la sonde électro-optique, de sorte que les impulsions 18, 19 se propagent à travers le cristal dans des directions opposées.

L'angle A est inférieur ou égal à 47°, de sorte que la réflexion des impulsions 18, 19 sur les faces obliques 34, 36 soient totales. Typiquement, les impulsions 18, 19 traversent le cristal sur une largeur d'une centaine de micromètres, et traversent chaque prisme sur une largeur d'environ 200 micromètres et sur une hauteur d'environ deux millimètres.

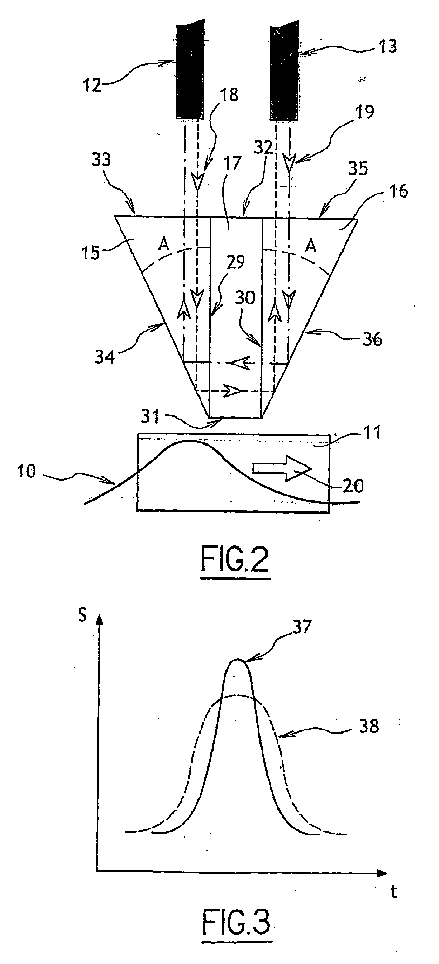

Sur la figure 2, les trajectoires des impulsions 18, 19 sont représentées espacées pour une meilleure clarté de la figure. En réalité, les trajectoires des impulsions 18, 19 sont de préférence sensiblement confondues.

Les fibres 12, 13 et la sonde électro-optique sont agencées pour que les impulsions 18, 19 se propagent le plus près possible et sensiblement parallèlement au plan de la face inférieure 31 du cristal 17. Une platine de translation 21 à trois axes permet de déplacer de façon solidaire les extrémités distales (c'est-à-dire orientées vers le circuit 11) des fibres 12, 13 par lesquels sortent les impulsions 18, 19, et la sonde électro-optique 14. La platine 21 permet ainsi de positionner la face inférieure 31 à proximité d'une partie 39 du circuit 11, de sorte que le signal électrique 10, généré par la même impulsion laser que les impulsions 18, 19, se propage sous la face 31 de la sonde électro-optique 14 en même temps que les impulsions 18, 19 traversent le cristal, et de sorte que le signal électrique 10 ait une direction de propagation sensiblement colinéaire à la direction de propagation d'une des impulsions optiques 18.

En se propageant dans le circuit 11 situé à proximité de la sonde électro-optique, le signal électrique soumet le cristal à un champ électrique. Les indices de réfraction du cristal varient, et la polarisation de chacune des première et deuxième impulsions 18, 19 varie durant leur traversée du cristal 17.

Après avoir traversé le cristal 17, la première impulsion 18 pénètre à l'intérieur de la deuxième fibre 13 par son extrémité distale. Le deuxième circulateur fibré 23 dirige la première impulsion 18 vers une photodiode 27 précédée par un système polarisant 25. De même, après avoir traversé le cristal 17, la deuxième impulsion 19 pénètre à l'intérieur de la première fibre 12 par son extrémité distale. Le premier circulateur fibré 22 dirige l'impulsion 19 vers une photodiode 26 précédée par un système polarisant 24. Le système polarisant 25, 24 permet de transcrire la variation de polarisation respectivement de la première ou de la deuxième impulsion 18 ou 19 en une variation d'intensité lumineuse, mesurée respectivement par la photodiode 27 ou 26.

Les photodiodes 26, 27 permettent donc de faire deux mesures simultanées : dans une première mesure, l'impulsion optique 18 se propageant à travers le cristal et le signal électrique se propageant à proximité de la face inférieure 31 du cristal ont une même direction de propagation; et dans une deuxième mesure, l'impulsion optique 19 se propageant à travers le cristal et le signal électrique se propageant à proximité de la face inférieure 31 du cristal ont des directions de propagation opposées.

Le signal électrique 10 qui se propage induit une propagation d'un champ électrique dans le cristal électro-optique 17. Pendant sa propagation, le champ électrique fait varier les indices de réfraction du cristal 17. Lorsque les faisceaux lumineux 18, 19 se propagent dans le milieu, la variation d'indice de réfraction fait varier les polarisations du premier et du deuxième faisceau lumineux. Ainsi, le premier 18 et deuxième 19 faisceau lumineux interagissent avec le signal électrique par l'intermédiaire du cristal électro-optique 17. Le temps d'interaction d'un des faisceaux avec le champ ou le signal électrique dépend notamment de l'angle entre la direction de propagation dudit faisceau et la direction de propagation du signal électrique. La variation de la polarisation d'un des faisceaux et donc le signal d'intensité au cours du temps mesuré sur le faisceau dépendent de ce temps d'interaction et donc de la direction de propagation du faisceau. De plus, la mesure de la variation de la polarisation est proportionnelle à la valeur du signal ou du champ au moment où le faisceau interagit avec le signal par l'intermédiaire du milieu.

Les signaux mesurés S en fonction du temps t sont illustrés sur la figure 3 pour les deux mesures. De manière préférentielle, les photodiodes 26, 27 sont positionnées le plus près possible du cristal 17 pour limiter le bruit sur les signaux mesurés. L'utilisation de détections synchrones permet en outre de réduire ce bruit.

Pour la première mesure, le signal mesuré par la photodiode 27 est non distordu. Pour la deuxième mesure, le signal mesuré 28 par la photodiode 26 est élargi temporellement à cause des vecteurs de propagation de l'impulsion optique 19 et de le signal électrique 10 contra-propagatifs. Une unité électronique de traitement et d'analyse des mesures permet de déterminer la direction de propagation du signal électrique 10. La comparaison des deux mesures permet donc de déterminer l'information de la direction de propagation 20 du signal électrique 10 : le signal électrique se propage dans la même direction que l'impulsion optique pour laquelle la variation de polarisation mesurée est la plus importante et la moins élargie temporellement. La valeur du signal 10 et du champ électrique est celle mesurée par la photodiode 27 sur impulsion optique 18 se propageant dans la même direction que le signal électrique 10.

La détermination de la direction de propagation utilise le fait que le résultat d'une mesure est différent si le signal électrique 10 et le faisceau lumineux 18 ou 19 se propagent dans la même direction ou sont contra-propagatifs. Dans une configuration telle que celle d'un dispositif selon le document [2], le résultat de la mesure est insensible à la direction de propagation du signal électrique puisque le faisceau lumineux de mesure et le signal électrique sont perpendiculaires.

Le dispositif selon l'invention comprend en outre une ligne à retard fibrée 28, permettant de faire varier un retard entre la génération du signal électrique 10 se propageant et les propagations des impulsions optiques 18, 19 à travers le cristal. Une variation de ce retard permet par exemple, avec l'aide de l'unité de traitement et d'analyse:
- de déterminer le profil temporel du signal électrique 10,
- d'échantillonner la réponse du circuit 11 à tester et de déterminer ainsi la réponse électrique temporelle du circuit, ou
- de caractériser des échos parasites ou des rebonds du signal électrique' dus, par exemple, à des phénomènes de désadaptation d'impédance dans le circuit 11.

La caractérisation d'un écho (ou d'un rebond) comprend typiquement la détermination de la valeur du champ électrique de l'écho, la détermination d'un profil temporel de l'écho, la détermination du délai entre l'écho et le signal électrique 10 à l'origine de l'écho, ou encore la détermination de la direction de propagation de l'écho. La détermination de la direction de propagation de l'écho est réalisée de la même manière que la détermination de la direction de propagation du signal électrique 10, au moyen des deux signaux lumineux 18, 19.

De manière préférentielle, le cristal 17 est choisi de sorte que son indice de réfraction soit sensiblement le même à la fréquence optique du faisceau 18 traversant le cristal (correspondant à la longueur d'onde du faisceau 18) et à une fréquence du signal électrique 10 (typiquement la transformée de Fourrier du signal électrique, de l'ordre du térahertz). Ainsi, l'impulsion 18 se propage dans le cristal avec sensiblement la même vitesse de propagation que le champ électrique qui est induit dans le cristal par la propagation du signal électrique. Ainsi, la résolution temporelle et la bande passante du dispositif selon l'invention ne dépendent sensiblement que de la durée de l'impulsion optique 18. Un dispositif selon l'invention peut typiquement avoir une bande passante supérieure à 300 gigahertz, et une résolution temporelle de l'ordre de quelques femtosecondes.

Dans une configuration telle que celle d'un dispositif selon le document [2], l'impulsion optique se propageant à travers le cristal et le signal électrique sont perpendiculaires. Le signal électrique induit un champ électrique se propageant dans le cristal. Durant toute la traversée longitudinale de l'impulsion optique, le champ électrique qui se propage latéralement dans le cristal est moyenné. La résolution temporelle d'une telle configuration est donc limitée par le temps d'interaction entre l'impulsion optique et le champ électrique présent dans le cristal, et est typiquement de 2,2 ps pour une épaisseur de cristal de 100 micromètres. Cela équivaut à une bande passante de 220 gigahertz.

Bien sûr, l'invention n'est pas limitée aux exemples qui viennent d'être décrits et de nombreux aménagements peuvent être apportés à ces exemples sans sortir du cadre de l'invention.

On peut imaginer une variante du mode de réalisation décrit, dans laquelle les mesures de variation d'une propriété optique ne sont pas réalisées simultanément pour les deux faisceaux lumineux. Des moyens pour qu'un même signal électrique se propage plusieurs fois de suite peuvent permettre de réaliser à deux instants différents une première et une deuxième mesure de variation d'une propriété optique respectivement du premier ou du deuxième faisceau lumineux.

De plus, les directions de propagations des premier et deuxième faisceaux lumineux à travers le milieu électro-optique ne sont pas nécessairement toutes deux parallèles à la direction de propagation du signal électrique, mais peuvent se propager dans des directions différentes à celle du signal électrique. On peut par exemple imaginer une configuration dans laquelle un des faisceaux lumineux a seulement une première composante de propagation colinéaire à la direction de propagation du signal électrique (une deuxième composante de propagation de ce faisceau étant sensiblement perpendiculaire à la direction de propagation du signal), et dans laquelle l'autre faisceau lumineux a seulement une composante de propagation opposée à ladite première composante (une autre composante de propagation de ce faisceau étant sensiblement perpendiculaire à la direction dé propagation du signal). Dans ce cas, les temps d'interaction des deux faisceaux avec le champ électrique induit par le signal électrique sont différents. Les variations de polarisations du premier et du deuxième faisceaux sont différents, ce qui permet de déterminer la direction de propagation du signal électrique.

Enfin, un dispositif ou un procédé selon l'invention n'est pas limité à la caractérisation d'un signal électrique se propageant dans un échantillon situé à proximité d'un milieu électro-optique à travers lequel se propage les premier et deuxième faisceaux lumineux, mais peut aussi être appliqué pour caractériser et déterminer le sens de propagation d'un signal électrique se propageant directement dans le milieu électro-optique.

### Références

Document [1]: demande de brevet US 2002/0 017 913 A1
Document [2]: « A 210-GHz Bandwidth Electrooptic Sampler for Large Signal Characterization of InP-Based Components », IEEE Photonics Technology Letters, vol. 17, no.12, Décembre 2005
Document [3]: « Subpicosecond Electrooptic Sampling : Principles and Applications », IEEE Journal of Quantum Electronics, vol. QE-22, no. 1, janvier 1986
Document [4]: brevet US 4 681 449

## Revendications

1. Procédé pour caractériser un signal électrique (10), comprenant :
- une propagation d'un premier faisceau lumineux (18) à travers un milieu électro-optique (17) selon une première direction de propagation, au moins une propriété optique du milieu variant lorsqu'il est soumis à un champ électrique.
- une propagation d'un deuxième faisceau lumineux (19) à travers le milieu électro-optique selon une deuxième direction de propagation différente de la première direction,
- pour chacun des faisceaux lumineux, une mesure d'une variation d'une propriété optique du faisceau lumineux (18 ; 19) due à sa propagation dans le milieu électro-optique (17), et
- une détermination, à partir des mesures, d'une direction de propagation (20) du signal électrique (10) soumettant le milieu électro-optique (17) à un champ électrique.

2. Procédé selon la revendication 1, **caractérisé en ce que** les propagations des deux faisceaux lumineux à travers le milieu électro-optique sont sensiblement simultanées, de sorte que le signal électrique modifie au moins une propriété optique du milieu électro-optique lors des propagations des faisceaux lumineux à travers le milieu électro-optique.

3. Procédé selon la revendication 1, **caractérisé en ce que** les propagations des deux faisceaux lumineux à travers le milieu électro-optique sont espacées temporellement, le signal électrique se propageant deux fois de suite de manière à modifier au moins une propriété optique du milieu électro-optique lors de chacune des propagations des faisceaux lumineux à travers le milieu électro-optique.

4. Procédé selon l'une des revendications 1 à 3, **caractérisé en ce que** les première et deuxième directions de propagation sont sensiblement opposées.

5. Procédé selon la revendication 4, **caractérisé en ce que** les deux faisceaux se propagent dans le milieu selon des trajectoires sensiblement confondues.

6. Procédé selon l'une des revendications 1 à 5, **caractérisé en ce que** la direction de propagation d'un des faisceaux lumineux (18) est sensiblement colinéaire à la direction de propagation (20) du signal électrique (10).

7. Procédé selon l'une des revendications 1 à 6, **caractérisé en ce qu'**au moins un des faisceaux lumineux (18 ; 19) consiste en une impulsion optique.

8. Procédé selon la revendication 7, **caractérisé en ce qu'**il comprend une génération des deux faisceaux lumineux (18 ; 19) par une même impulsion optique.

9. Procédé selon l'une des revendications 1 à 8, **caractérisé en ce que** les propriétés du milieu (17) variant lorsqu'il est soumis à un champ électrique comprennent au moins un indice de réfraction du milieu.

10. Procédé selon l'une des revendications 1 à 9, **caractérisé en ce que**, pour au moins un des faisceaux lumineux (18 ; 19), la mesure comprend une mesure d'une variation de la polarisation du faisceau lumineux ou une mesure d'une variation d'intensité du faisceau.

11. Procédé selon la revendication 10, **caractérisé en ce qu'**il comprend en outre une transcription de la variation de polarisation du faisceau lumineux en une variation d'intensité du faisceau lumineux.

12. Procédé selon l'une des revendications 1 à 11, **caractérisé en ce qu'**il comprend en outre une génération du signal électrique se propageant (10).

13. Procédé selon la revendication 12, **caractérisé en ce que** la génération du signal électrique comprend une transcription d'une impulsion optique de déclenchement en le signal électrique (10).

14. procédé selon la revendication 13, caractérisé en-ce-qu'il comprend en outre une génération de l'impulsion optique de déclenchement et d'au moins un des faisceaux lumineux par une même impulsion optique initiale.

15. Procédé selon l'une des revendications 12 à 14, **caractérisé en ce qu'**il comprend en outre une variation d'un retard entre la génération du signal électrique et les propagations des faisceaux lumineux à travers le milieu électro-optique.

16. Procédé selon l'une des revendications 1 à 15, **caractérisé en ce qu'**il comprend en outre une détermination d'un profil temporel du signal électrique.

17. Procédé selon l'une des revendications 1 à 16, **caractérisé en ce qu'**il comprend en outre une caractérisation d'échos parasites et/ou de rebonds du signal électrique.

18. Dispositif pour caractériser un signal électrique, comprenant :
- des moyens (1, 5, 15, 33, 34) pour propager un premier faisceau lumineux à travers un milieu électro-optique (17) selon une première direction de propagation, au moins une propriété optique du milieu (17) variant lorsqu'il est soumis à un champ électrique,
- des moyens (1, 5, 16, 35, 36) pour propager un deuxième faisceau lumineux à travers le milieu électro-optique (17) selon une deuxième direction de propagation différente de la première direction,
- pour chacun des faisceaux lumineux, des moyens pour mesurer (25, 27 ; 24, 26) une variation d'une propriété optique du faisceau lumineux (18 ; 19) due à sa propagation dans le milieu électro-optique (17), et
- des moyens pour déterminer; à partir des mesures de variation, une direction de propagation (20) du signal électrique (10) soumettant le milieu à un champ électrique.

19. Dispositif selon la revendication 18, **caractérisé en ce qu'**il est agencé pour que les première et deuxième directions de propagation soient sensiblement opposées.

20. Dispositif selon la revendication 19, **caractérisé en ce qu'**il est agencé pour que les deux faisceaux aient des trajectoires de propagation dans le milieu sensiblement confondues.

21. Dispositif selon l'une des revendications 18 à 20, **caractérisé en ce qu'**il est agencé pour que la direction de propagation d'un des faisceaux lumineux (18) soit sensiblement colinéaire à la direction de propagation (20) du signal électrique (10).

22. Dispositif selon l'une des revendications 18 à 21, **caractérisé en ce qu'**il comprend des moyens (1, 5) pour générer le premier (18) et le deuxième (19) faisceau lumineux à partir d'une même impulsion optique.

23. Dispositif selon l'une des revendications 18 à 22, **caractérisé en ce que**, pour au moins un des faisceaux lumineux, les moyens de mesure comprennent des moyens (24, 26 ; 25, 27) pour mesurer une variation de la polarisation du faisceau lumineux (19 ; 18) ou des moyens pour mesurer une variation d'intensité du faisceau.

24. Dispositif selon la revendication 23, **caractérisé en ce qu'**il comprend en outre des moyens (24; 25) pour transcrire une variation de polarisation du faisceau lumineux (19 ; 18) en une variation d'intensité du faisceau lumineux.

25. Dispositif selon l'une des revendications 18 à 24, **caractérisé en ce qu'**il comprend en outre des moyens (28) pour déterminer un profil temporel du signal électrique.

26. Dispositif selon l'une des revendications 18 à 25, **caractérisé en ce qu'**il comprend en outre des moyens (28) pour caractériser des échos parasites ou des rebonds du signal électrique.

27. Dispositif selon l'une des revendications 18 à 26, caractérisé en que le milieu électro-optique comprend un cristal électro-optique, de préférence un cristal de Tantalate de Lithium, de Telluride de Zinc ou de (diéthylamino)sulfur trifluoride.

28. Dispositif selon l'une des revendications 18 à 27, **caractérisé en ce que** l'indice de réfraction du milieu électro-optique à une fréquence optique d'au moins un des faisceaux lumineux est sensiblement égale à l'indice de réfraction du milieu étectro-optique à une fréquence du signal électrique.

29. Dispositif selon l'une des revendications 18 à 28, **caractérisé en ce qu'**il comprend en outre des moyens (1, 2, 6, 7, 8, 9) pour générer le signal électrique se propageant.

30. Dispositif selon la revendication 29, **caractérisé en ce que** les moyens de génération du signal électrique comprennent des moyens (9) pour transcrire une impulsion optique de déclenchement en le signal électrique.

31. Dispositif selon la revendication 30, **caractérisé en ce qu'**il comprend en outre des moyens. (1, 2, 6) pour générer l'impulsion optique de déclenchement et au moins un des faisceaux lumineux (18 ; 19) à partir d'une même impulsion optique initiale.

32. Dispositif selon l'une des revendications 29 à 31, **caractérisé en ce qu'**il comprend en outre des moyens (28) pour varier un retard entre la génération du signal électrique se propageant et les propagations des faisceaux lumineux (18, 19) à travers le milieu (17).

33. Dispositif selon l'une des revendications 18 à 32, **caractérisé en ce que** le signal électrique se propage dans un échantillon à caractériser.

34. Dispositif selon l'une des revendications 18 à 33, **caractérisé en ce que** le milieu électro-optique (17) fait partie d'une sonde électro-optique (14) prévue pour être placée à proximité d'un échantillon (11) dans lequel se propage le signal électrique (10).

35. Dispositif selon la revendication 34, **caractérisé en ce que** la sonde électro-optique (14) comprend :
- le milieu électro-optique (17) dont au moins une propriété optique varie lorsqu'il est soumis à un champ électrique,
- des moyens (15, 16) pour collecter le premier et le deuxième faisceau lumineux ayant sensiblement une même direction de propagation vers la sonde electro-optique, et
- les moyens (15, 16) pour propager le premier faisceau lumineux et le deuxième faisceau lumineux à travers le milieu électro-optique selon des directions de propagation différentes.

36. Dispositif selon la revendication 34 ou 35, **caractérisé en ce que** la sonde électro-optique (14) comprend deux prismes (15, 16) situés respectivement le long d'une première. (29) et deuxième (30) face latérale du milieu électro-optique (17), les prismes étant disposés sensiblement symétriquement par rapport à un plan passant à travers le milieu électro-optique (17).

37. Dispositif selon la revendication 36, **caractérisé en ce que** le milieu électro-optique (17) a sensiblement la forme d'un parallélépipède rectangle, **en ce qu'**il comprend deux faces dites supérieure (32) et inférieure (31) opposées et sensiblement perpendiculaires aux faces latérales (29, 30), la face inférieure (31) étant prévue pour être placée à proximité de l'échantillon (11) dans lequel se propage le signal électrique, et **en ce que** chaque prisme comprend :
- une première face le long d'une des faces latérales (29 ; 30),
- une deuxième face (33 ; 35) prévue pour collecter le premier (18) ou deuxième (19) faisceau lumineux, et formant avec ladite une des faces latérales (29; 30) et du côté de la face supérieure (32) un angle sensiblement droit,
- une troisième face (34 ; 36) formant avec ladite une des faces latérales (29 ; 30) et du côté de la face inférieure (31) un angle aigu, ladite troisième face étant agencée pour réfléchir le premier (18) ou le deuxième (19) faisceau de la deuxième face (33 ; 35) vers le milieu électro-optique (17) ou inversement.

## Claims

1. Process for characterising an electric signal (10), comprising:
- a propagation of a first light beam (18) through an electro-optic medium (17) in a first direction of propagation, at least one optical property of the medium varying when it is subjected to an electric field,
- a propagation of a second light beam (19) through the electro-optic medium in a second direction of propagation different from the first direction,
- for each of the light beams, a measurement of a variation of an optical property of the light beam (18; 19) due to its propagation in the electro-optic medium (17), and
- a determination, from the measurements, of a direction of propagation (20) of the electric signal (10) subjecting the electro-optic medium (17) to an electric field.

2. Process according to claim 1, **characterized in that** the propagations of the two light beams through the electro-optic medium are substantially simultaneous, such that the electric signal modifies at least one optical property of the electro-optic medium during the propagations of the light beams through the electro-optic medium.

3. Process according to claim 1, **characterized in that** in the propagations of the two light beams through the electro-optic medium are spaced temporally, the electric signal propagating twice in succession in such a way as to modify at least one optical property of the electro-optic medium during each of the propagations of the light beams through the electro-optic medium.

4. Process according to one of the claims 1 to 3, **characterized in that** the first and second directions of propagation are substantially opposite.

5. Process according to claim 4, **characterized in that** the two beams propagate in the medium along substantially merged paths.

6. Process according to one of the claims 1 to 5, **characterized in that** the direction of propagation of one of the light beams (18) is substantially collinear with the direction of propagation (20) of the electric signal (10).

7. Process according to one of the claims 1 to 6, **characterized in that** at least one of the light beams (18; 19) consists of an optical pulse.

8. Process according to claim 7, **characterized in that** it comprises a generation of the two light beams (18; 19) by a same optical pulse.

9. Process according to one of the claims 1 to 8, **characterized in that** the properties of the medium (17) varying when it is subjected to an electric field comprise at least one refractive index of the medium.

10. Process according to one of the claims 1 to 9, **characterized in that**, for at least one of the light beams (18; 19), the measurement comprises a measurement of a variation of the polarisation of the light beam or a measurement of a variation of intensity of the beam.

11. Process according to claim 10, **characterized in that** it comprises moreover a conversion of the variation of polarisation of the light beam into a variation of intensity of the light beam.

12. Process according to one of the claims 1 to 11, **characterized in that** it comprises moreover a generation of the propagating electric signal (10).

13. Process according to claim 12, **characterized in that** the generation of the electric signal comprises a conversion of an optical triggering pulse into the electric signal (10).

14. Process according to claim 13, **characterized in that** it comprises moreover a generation of the optical triggering pulse and of at least one of the light beams by a same initial optical pulse.

15. Process according to one of the claims 12 to 14, **characterized in that** it comprises moreover a variation of a delay between the generation of the electric signal and the propagations of the light beams through the electro-optic medium.

16. Process according to one of the claims 1 to 15, **characterized in that** it comprises moreover a determination of a temporal profile of the electric signal.

17. Process according to one of the claims 1 to 16, **characterized in that** it comprises moreover a characterisation of parasitic echoes and/or of rebounds of the electric signal.

18. Device for characterising an electric signal, comprising:
- means (1, 5, 15, 33, 34) for propagating a first light beam through an electro-optic medium (17) in a first direction of propagation, at least one optical property of the medium (17) varying when it is subjected to an electric field,
- means (1, 5, 16, 35, 36) for propagating a second light beam through the electro-optic medium (17) in a second direction of propagation different from the first direction,
- for each of the light beams, means (25, 27; 24, 26) for measuring a variation of an optical property of the light beam (18; 19) due to its propagation in the electro-optic medium (17), and
- means for determining, from the measurements of variation, a direction of propagation (20) of the electric signal (10) subjecting the medium to an electric field.

19. Device according to claim 18, **characterized in that** it is arranged such that the first and second directions of propagation of the light beams are substantially opposite.

20. Device according to claim 19, **characterized in that** it is arranged such that the two light beams have substantially merged propagation paths in the medium.

21. Device according to one of the claims 18 to 20, **characterized in that** it is arranged such that the direction of propagation of one of the light beams (18) is substantially collinear with the direction of propagation (20) of the electric signal (10).

22. Device according to one of the claims 18 to 21, **characterized in that** it comprises means (1, 5) for generating the first (18) and the second (19) light beams from a same optical pulse.

23. Device according to one of the claims 18 to 22, **characterized in that**, for at least one of the light beams, the measuring means comprise means (24, 26; 25, 27) for measuring a variation of the polarisation of the light beam (19; 18), or means for measuring a variation of intensity of the beam.

24. Device according to claim 23, **characterized in that** it comprises moreover means (24; 25) for converting a variation of polarisation of the light beam (19; 18) into a variation of intensity of the light beam.

25. Device according to one of the claims 18 to 24, **characterized in that** it comprises moreover means (28) for determining a temporal profile of the electric signal.

26. Device according to one of the claims 18 to 25, **characterized in that** it comprises moreover means (28) for characterising parasitic echoes or rebounds of the electric signal.

27. Device according to one of the claims 18 to 26, **characterized in that** the electro-optic medium comprises an electro-optic crystal, preferably a crystal of lithium tantalite, zinc telluride or (diethyl amino)sulphur trifluoride.

28. Device according to one of the claims 18 to 27, **characterized in that** the refractive index of the electro-optic medium at an optical frequency of at least one of the light beams is substantially equal to the refractive index of the electro-optic medium at a frequency of the electric signal.

29. Device according to one of the claims 18 to 28, **characterized in that** it comprises moreover of the means (1, 2, 6, 7, 8, 9) for generating the propagating electric signal.

30. Device according to claim 29, **characterized in that** the means for generating the electric signal comprise means (9) for converting an optical triggering pulse into the electric signal.

31. Device according to claim 30, **characterized in that** it comprises moreover means (1, 2, 6) for generating the optical triggering pulse and at least one of the light beams (18; 19) from the same initial optical pulse.

32. Device according to one of the claims 29 to 31, **characterized in that** it comprises moreover means (28) for varying a delay between the generation of the propagating electric signal and the propagations of the light beams (18, 19) through the medium (17).

33. Device according to one of the claims 18 to 32, **characterized in that** the electric signal propagates in a sample to be characterised.

34. Device according to one of the claims 18 to 33, **characterized in that** the electro-optic medium (17) is part of an electro-optic probe (14) provided so as to be placed close to a sample (11) in which the electric signal (10) propagates.

35. Device according to claim 34, **characterized in that** the electro-optic probe (14) comprises:
- the electro-optic medium (17) of which at least one optical property varies when it is subjected to an electric field,
- means (15, 16) for collecting the first light beam and the second light beam having substantially the same direction of propagation towards the electro-optic probe, and
- means (15, 16) for propagating the first light beam and the second light beam through the electro-optic medium in different directions of propagation.

36. Device according to claim 34 or 35, **characterized in that** the electro-optic probe (14) comprises two prisms (15, 16) situated along a first lateral face (29) and a second lateral face (30) of the electro-optic medium (17) respectively, the prisms being arranged substantially symmetrically with respect to a plane passing through the electro-optic medium (17).

37. Device according to claim 36, **characterized in that** the electro-optic medium (17) has substantially the shape of a right-angled parallelepiped and **in that** it comprises two opposite faces called upper (32) and lower (31) and substantially perpendicular to the lateral faces (29, 30), the lower face (31) being provided so as to be placed close to a sample (11) in which the electric signal propagates, and **in that** each prism comprises:
- a first face along one of the lateral faces (29; 30),
- a second face (33; 35) provided for collecting the first (18) or the second (19) light beam, and forming with said one of the lateral faces (29; 30) a substantially right angle at the upper face (32) side,
- a third face (34; 36) forming with said one of the lateral faces (29; 30) an acute angle at the lower face (31) side, said third face being arranged in order to reflect the first (18) or the second beam (19) from the second face (33; 35) towards the electro-optic medium (17) or vice-versa.

## Patentansprüche

1. Verfahren zum Charakterisieren eines elektrischen Signals (10), umfassend:
- eine Ausbreitung eines ersten Lichtstrahls (18) durch ein elektrooptisches Medium (17) in einer ersten Ausbreitungsrichtung, wobei sich wenigstens eine optische Eigenschaft des Mediums ändert, wenn es einem elektrischen Feld ausgesetzt wird,
- eine Ausbreitung eines zweiten Lichtstrahls (19) durch das elektrooptische Medium in einer von der ersten Richtung abweichenden zweiten Ausbreitungsrichtung,
- für einen jeden der Lichtstrahlen eine Messung einer Änderung einer optischen Eigenschaft des Lichtstrahls (18; 19), die durch seine Ausbreitung in dem elektrooptischen Medium (17) bedingt ist, und
- ein Bestimmen, anhand der Messungen, einer Ausbreitungsrichtung (20) des elektrischen Signals (10), das das elektrooptische Medium (17) einem elektrischen Feld aussetzt.

2. Verfahren nach Anspruch 1, **dadurch gekennzeichnet, dass** die Ausbreitungen der beiden Lichtstrahlen durch das elektrooptische Medium im Wesentlichen gleichzeitig erfolgen, so dass das elektrische Signal wenigstens eine optische Eigenschaft des elektrooptischen Mediums während der Ausbreitungen der Lichtstrahlen durch das elektrooptische Medium verändert.

3. Verfahren nach Anspruch 1, **dadurch gekennzeichnet, dass** die Ausbreitungen der beiden Lichtstrahlen durch das elektrooptische Medium zeitlich beabstandet sind, wobei das elektrische Signal sich zweimal hintereinander ausbreitet, so dass wenigstens eine optische Eigenschaft des elektrooptischen Mediums bei einer jeden der Ausbreitungen der Lichtstrahlen durch das elektrooptische Medium verändert wird.

4. Verfahren nach einem der Ansprüche 1 bis 3, **dadurch gekennzeichnet, dass** die erste und die zweite Ausbreitungsrichtung im Wesentlichen entgegengesetzt sind.

5. Verfahren nach Anspruch 4, **dadurch gekennzeichnet, dass** die beiden Strahlen sich in dem Medium entlang von im Wesentlichen miteinander verschmolzenen Bahnen ausbreiten.

6. Verfahren nach einem der Ansprüche 1 bis 5, **dadurch gekennzeichnet, dass** die Ausbreitungsrichtung von einem der Lichtstrahlen (18) zu der Ausbreitungsrichtung (20) des elektrischen Signals (10) im Wesentlichen kollinear ist.

7. Verfahren nach einem der Ansprüche 1 bis 6, **dadurch gekennzeichnet, dass** wenigstens einer der Lichtstrahlen (18; 19) aus einem optischen Impuls besteht.

8. Verfahren nach Anspruch 7, **dadurch gekennzeichnet, dass** es ein Erzeugen der beiden Lichtstrahlen (18; 19) durch einen gleichen optischen Impuls umfasst.

9. Verfahren nach einem der Ansprüche 1 bis 8, **dadurch gekennzeichnet, dass** die Eigenschaften des Mediums (17), die sich ändern, wenn es einem elektrischen Feld ausgesetzt wird, wenigstens einen Brechungsindex des Mediums umfassen.

10. Verfahren nach einem der Ansprüche 1 bis 9, **dadurch gekennzeichnet, dass** für wenigstens einen der Lichtstrahlen (18; 19) die Messung eine Messung einer Änderung der Polarisation des Lichtstrahls oder eine Messung einer Änderung der Intensität des Strahls umfasst.

11. Verfahren nach Anspruch 10, **dadurch gekennzeichnet, dass** es ferner ein Umsetzen der Polarisationsänderung des Lichtstrahls in eine Intensitätsänderung des Lichtstrahls umfasst

12. Verfahren nach einem der Ansprüche 1 bis 11, **dadurch gekennzeichnet, dass** es ferner ein Erzeugen des sich ausbreitenden elektrischen Signals (10) umfasst.

13. Verfahren nach Anspruch 12, **dadurch gekennzeichnet, dass** das Erzeugen des elektrischen Signals ein Umsetzen eines optischen Auslöseimpulses in das elektrische Signal (10) umfasst.

14. Verfahren nach Anspruch 13, **dadurch gekennzeichnet, dass** es ferner ein Erzeugen des optischen Auslöseimpulses sowie wenigstens eines der Lichtstrahlen durch einen gleichen optischen Ausgangsimpuls umfasst.

15. Verfahren nach einem der Ansprüche 12 bis 14, **dadurch gekennzeichnet, dass** es ferner eine Änderung einer Verzögerung zwischen dem Erzeugen des elektrischen Signals und den Ausbreitungen der Lichtstrahlen durch das elektrooptische Medium umfasst.

16. Verfahren nach einem der Ansprüche 1 bis 15, **dadurch gekennzeichnet, dass** es ferner ein Festlegen eines Zeitprofils des elektrischen Signals umfasst.

17. Verfahren nach einem der Ansprüche 1 bis 16, **dadurch gekennzeichnet, dass** es ferner eine Charakterisierung von Störechos und/oder von Prellungen des elektrischen Signals umfasst.

18. Vorrichtung zum Charakterisieren eines elektrischen Signals, umfassend:
- Mittel (1, 5, 15, 33, 34), um einen ersten Lichtstrahl durch ein elektrooptisches Medium (17) in einer ersten Ausbreitungsrichtung auszubreiten, wobei sich wenigstens eine optische Eigenschaft des Mediums (17) ändert, wenn es einem elektrischen Feld ausgesetzt wird,
- Mittel (1, 5, 16, 35, 36), um einen zweiten Lichtstrahl durch das elektrooptische Medium (17) in einer von der ersten Richtung abweichenden zweiten Ausbreitungsrichtung auszubreiten,
- für einen jeden der Lichtstrahlen Mittel zum Messen (25, 27; 24, 26) einer Änderung einer optischen Eigenschaft des Lichtstrahls (18; 19), die durch seine Ausbreitung in dem elektrooptischen Medium (17) bedingt ist, und
- Mittel zum Bestimmen, anhand der Änderungsmessungen, einer Ausbreitungsrichtung (20) des elektrischen Signals (10), das das Medium einem elektrischen Feld aussetzt.

19. Vorrichtung nach Anspruch 18, **dadurch gekennzeichnet, dass** sie eingerichtet ist, damit die erste und die zweite Ausbereitungsrichtung im Wesentlichen entgegengesetzt sind.

20. Vorrichtung nach Anspruch 19, **dadurch gekennzeichnet, dass** sie eingerichtet ist, damit die beiden Strahlen im Wesentlichen miteinander verschmolzene Ausbreitungsbahnen in dem Medium haben.

21. Vorrichtung nach einem der Ansprüche 18 bis 20, **dadurch gekennzeichnet, dass** sie eingerichtet ist, damit die Ausbreitungsrichtung von einem der Lichtstrahlen (18) zu der Ausbreitungsrichtung (20) des elektrischen Signals (10) im Wesentlichen kollinear ist.

22. Vorrichtung nach einem der Ansprüche 18 bis 21, **dadurch gekennzeichnet, dass** sie Mittel (1, 5) zum Erzeugen des ersten (18) und des zweiten (19) Lichtstrahls mittels eines gleichen optischen Impulses umfasst.

23. Vorrichtung nach einem der Ansprüche 18 bis 22, **dadurch gekennzeichnet, dass** für wenigstens einen der Lichtstrahlen die Messmittel Mittel (24, 26; 25, 27) zum Messen einer Änderung der Polarisation des Lichtstrahls (19; 18) oder Mittel zum Messen einer Änderung der Intensität des Strahls umfassen.

24. Vorrichtung nach Anspruch 23, **dadurch gekennzeichnet, dass** sie ferner Mittel (24; 25) zum Umsetzen einer Polarisationsänderung des Lichtstrahls (19; 18) in eine Intensitätsänderung des Lichtstrahls umfasst.

25. Vorrichtung nach einem der Ansprüche 18 bis 24, **dadurch gekennzeichnet, dass** sie ferner Mittel (28) zum Festlegen eines Zeitprofils des elektrischen Signals umfasst.

26. Vorrichtung nach einem der Ansprüche 18 bis 25, **dadurch gekennzeichnet, dass** sie ferner Mittel (28) zum Charakterisieren von Störechos oder von Prellungen des elektrischen Signals umfasst.

27. Vorrichtung nach einem der Ansprüche 18 bis 26, **dadurch gekennzeichnet, dass** das elektrooptische Medium einen elektrooptischen Kristall, vorzugsweise einen Lithiumtantalat-, Zinktellurid- oder (Diethylamino)schwefeltrifluorid-Kristall umfasst.

28. Vorrichtung nach einem der Ansprüche 18 bis 27, **dadurch gekennzeichnet, dass** der Brechungsindex des elektrooptischen Mediums bei einer optischen Frequenz von wenigstens einem der Lichtstrahlen im Wesentlichen gleich dem Brechungsindex des elektrooptischen Mediums bei einer Frequenz des elektrischen Signals ist.

29. Vorrichtung nach einem der Ansprüche 18 bis 28, **dadurch gekennzeichnet, dass** sie ferner Mittel (1, 2, 6, 7, 8, 9) zum Erzeugen des sich ausbreitenden elektrischen Signals umfasst.

30. Vorrichtung nach Anspruch 29, **dadurch gekennzeichnet, dass** die Mittel zum Erzeugen des elektrischen Signals Mittel (9) zum Umsetzen eines optischen Auslöseimpulses in das elektrische Signal umfassen.

31. Vorrichtung nach Anspruch 30, **dadurch gekennzeichnet, dass** sie ferner Mittel (1, 2, 6) zum Erzeugen des optischen Auslöseimpulses und wenigstens eines der Lichtstrahlen (18; 19) mittels eines gleichen optischen Ausgangsimpulses umfasst.

32. Vorrichtung nach einem der Ansprüche 29 bis 31, **dadurch gekennzeichnet, dass** sie ferner Mittel (28) zum Verändern einer Verzögerung zwischen der Erzeugung des sich ausbreitenden elektrischen Signals und den Ausbreitungen der Lichtstrahlen (18, 19) durch das Medium (17) umfasst.

33. Vorrichtung nach einem der Ansprüche 18 bis 32, **dadurch gekennzeichnet, dass** das elektrische Signal sich in einer zu charakterisierenden Probe ausbreitet.

34. Vorrichtung nach einem der Ansprüche 18 bis 33, **dadurch gekennzeichnet, dass** elektrooptische Medium (17) zu einer elektrooptischen Sonde (14) gehört, die vorgesehen ist, um in der Nähe einer Probe (11), in der sich das elektrische Signal (10) ausbreitet, angeordnet zu werden.

35. Vorrichtung nach Anspruch 34, **dadurch gekennzeichnet, dass** die elektrooptische Sonde (14) umfasst:
- das elektrooptische Medium (17), wovon sich wenigstens eine optische Eigenschaft ändert, wenn es einem elektrischen Feld ausgesetzt wird,
- Mittel (15, 16) zum Sammeln des ersten und des zweiten Lichtstrahls, die im Wesentlichen eine gleiche Ausbreitungsrichtung zu der elektrooptischen Sonde haben, und
- die Mittel (15, 16) für das Ausbreiten des ersten Lichtstrahls und des zweiten Lichtstrahls durch das elektrooptische Medium in unterschiedlichen Ausbreitungsrichtungen.

36. Vorrichtung nach Anspruch 34 oder 35, **dadurch gekennzeichnet, dass** die elektrooptische Sonde (14) zwei Prismen (15, 16) umfasst, die entlang einer ersten (29) bzw. einer zweiten (30) Seitenfläche des elektrooptischen Mediums (17) gelegen sind, wobei die Prismen im Wesentlichen symmetrisch zu einer durch das elektrooptische Medium (17) verlaufenden Ebene angeordnet sind.

37. Vorrichtung nach Anspruch 36, **dadurch gekennzeichnet, dass** das elektrooptische Medium (17) im Wesentlichen die Form eines Quaders aufweist, dass es zwei Seiten, eine obere (32) und eine untere (31) umfasst, die einander gegenüberliegen und zu den Seitenflächen (29, 30) im Wesentlichen senkrecht verlaufen, wobei die untere Seite (31) vorgesehen ist, um in der Nähe der Probe (11), in der sich das elektrische Signal ausbreitet, angeordnet zu werden, und das jedes Prisma umfasst:
- eine erste Seite entlang von einer der Seitenflächen (29; 30),
- eine zweite Seite (33; 35), die vorgesehen ist, um den ersten (18) und den zweiten (19) Lichtstrahl zu sammeln, und die mit der einen der Seitenflächen (29; 30) und auf der Seite der oberen Seite (32) einen im Wesentlichen geraden Winkel bildet,
- eine dritte Seite (34; 36), die mit der einen der Seitenflächen (29; 30) und auf der Seite der unteren Seite (31) einen spitzen Winkel bildet, wobei die dritte Seite dazu ausgelegt ist, den ersten (18) oder den zweiten (19) Strahl von der zweiten Seite (33; 35) in Richtung des elektrooptischen Mediums (17) zu reflektieren oder umgekehrt.
